# EUROPEAN PATENT SPECIFICATION

(11) **EP 0 381 541 B1**
(45) Date of publication and mention of the grant of the patent: **04.01.1995**
(21) Application number: 90301176.5
(22) Date of filing: 05.02.1990
(51) Int. Cl.: H01L 43/08, H01L 39/22, H01L 27/18

(54) **Superconductive magnetoresistive device**
Supraleitende magnetoresistive Anordnung
Dispositif magnétorésistif supraconducteur

(30) Priority: 03.02.1989 JP 25992/89
(43) Date of publication of application: 08.08.1990
(73) Proprietor: SHARP KABUSHIKI KAISHA, Osaka 545 (JP)
(72) Inventor: Kita, Ryusuke, Urayasu-shi, Chiba (JP); Tsuchimoto, Shuhei, Kita-Katsuragi-gun, Nara (JP)
(74) Representative: Brown, Kenneth Richard

(56) References cited:
- EP-A- 0 326 741
- US-A- 4 454 522
- Proceedings of the International Electron Devices Meeting; San Francisco, CA; 11-14 Dec. 1988, pages 892 - 893; H.Nojima et al.: "Improvement in sensitivity of novel magnetic sensor using Y-Ba-Cu-O ceramic superconductor film."
- TRANSACTIONS OF THE INSTITUTE OF ELECTRONICS AND COMMUNICATION vol. E61, no. 8, August 1978, TOKYO, JP; pages 670 - 671; H.Fujisada et al.: "Geometrical effects in planar electrode type InSb magnetoresistance devices"
- Appl. Phys. Lett. 51(3), 20 July 1987, pp. 200 - 227, R. H. Koch et al.

## Description

The present invention relates to a superconductive magneto-resistive device, and more particularly, to a superconductive magneto-resistive device for detecting an extremely weak magnetic field.

### DESCRIPTION OF RELATED ART

Conventionally, there have been widely used magneto-resistive devices using a semiconductive material, and/or a magnetic material to detect a magnetic field. Also, often the material used for the magneto-resistive devices is a semiconductor having a high electron mobility such as InSb, InAs or the like.

Further, as a device for detecting a magnetic field, there has been developed a Superconductive Quantum Interference Device (hereinafter referred to as a SQUID), having an extremely high sensitivity. Furthermore, there has been proposed a superconductive magneto-resistive device with a high sensitivity, utilizing coupling properties of grain boundaries of a superconductor see Proceedings of the IEDM 88, 11-14 Dec. 1988, pp. 892-893, N. Nojima et al..

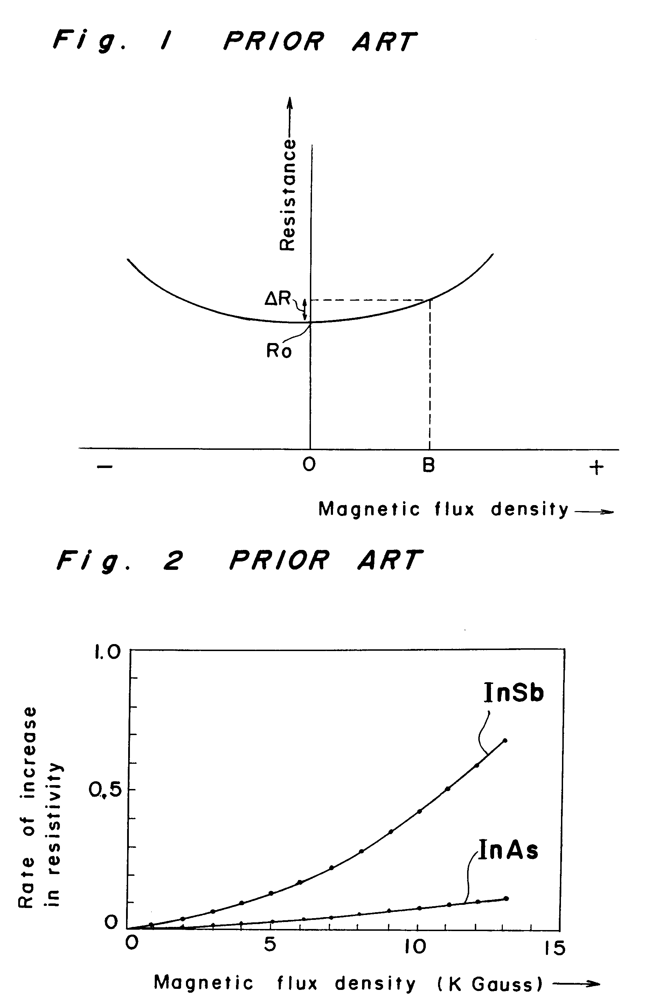

However, the conventional magneto-resistive devices using a semiconductor or a magnetic material have a resistance characteristic depending on a magnetic flux density to be applied thereto, as shown in Fig. 1.

As shown in Fig. 1, the resistance of the conventional magneto-resistive device increases according to a quadratic curve depending on a magnetic flux density. Therefore, a change ΔR in the resistance thereof is very small when a magnetic field to be measured is weak, and accordingly, only a very low sensitivity to a weak magnetic field is obtained.

Fig. 2 shows a relationship between a rate of increase in the resistivity of a typical conventional magneto-resistive semiconductive device including the material InSb or InAs and a magnetic flux density of a magnetic field to be applied thereto, namely, a sensitivity to the magnetic field applied thereto, which is obtained from Fig. 1.

As is also apparent from Fig. 2, the sensitivity of the conventional magneto-resistive device is very low so long as the magnetic flux density to be measured is weak.

The above-mentioned SQUID has an extremely high sensitivity to a weak magnetic field, however, it has disadvantages one being that it is difficult to handle, and secondly the output level thereof is relatively low.

Furthermore, in the developed superconductive magneto-resistive device utilizing coupling properties of grain boundaries of a superconductor, it is difficult to control the grain size thereof and properties of grain boundaries to obtain a desirable resistance characteristic depending on a magnetic flux density applied thereto upon fabricating it.

### SUMMARY OF THE INVENTION

It would therefore be desirable to provide a superconductive magneto-resistive device which is not only capable of detecting a magnetic field precisely with a sensitivity higher than the conventional devices but also one that can be easily handled.

According to the present invention, there is provided a superconductive magneto-resistive device comprising:
plural superconductive pieces formed onto a top surface of a non-magnetic substrate, said plural superconductive pieces forming a plurality of pairs, each of said plurality of pairs being formed from adjacent superconductive pieces separated by a small gap; and
films selected from the group consisting of a conductive or semiconductive material formed between each pair of said adjacent superconductive pieces on said substrate so as to be in contact with each pair of said adjacent superconductive pieces, said films functioning to form a weak coupling due to a proximity effect between each pair of said adjacent superconductive pieces.

### BRIEF DESCRIPTION OF THE DRAWINGS

Other features of the present invention will become clear from the following description taken in conjunction with the preferred embodiment thereof with reference to the accompanying drawings, in which:
Fig. 1 is a graph showing a resistance characteristic of a conventional magneto-resistive device of a semiconductor or a magnetic material depending on a magnetic flux density to be applied thereto;
Fig. 2 is a graph showing a relationship between a rate of increase in a resistivity of respective conventional magneto-resistive devices formed of InSb and InAs and a magnetic flux density of a magnetic field to be applied thereto;
Fig. 3a is a partial top plan view showing a superconductive magneto-resistive device of a preferred embodiment according to the present invention;
Fig. 3b is a partial cross sectional view taken on a line X - X′;
Figs. 4a, 4b, 4c and 4d are partial cross sectional views showing a process for fabricating the superconductive magneto-resistive device shown in Figs. 3a and 3b; and
Fig. 5 is a graph showing a resistance characteristic of the superconductive magneto-resistive device shown in Figs. 3a and 3b, depending on a magnetic flux density of a magnetic field to be applied thereto.

### DETAILED DESCRIPTION OF THE PREFERRED EMBODIMENT

A preferred embodiment according to the present invention will be described below with reference to the attached drawings.

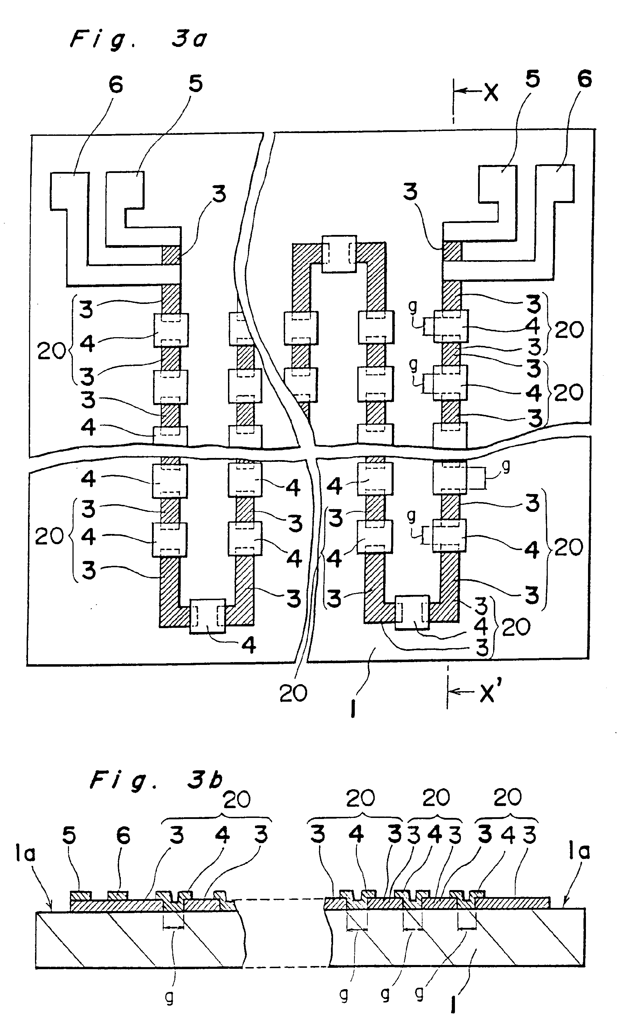

Figs. 3a and 3b illustrate a structure of a superconductive magneto-resistive device of a preferred embodiment according to the present invention.

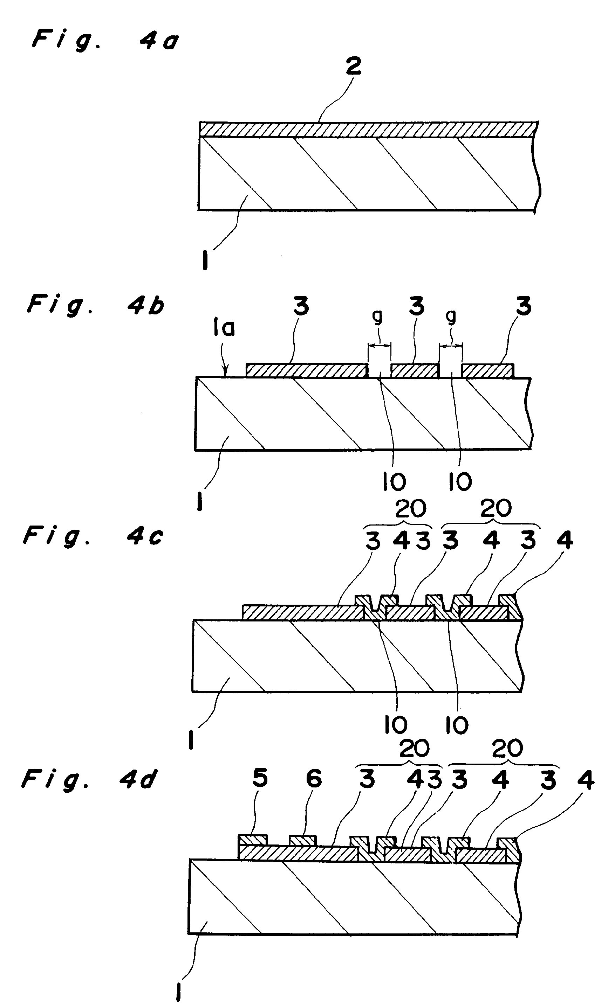

The superconductive magneto-resistive device of the preferred embodiment is characterized in that, plural superconductive pieces 3 are formed apart from each other with a small gap 10, see for example Fig. 4c drawing a length 9 on a non-magnetic magnesia substrate 1, and each pair of the adjacent two superconductive pieces 3 thereof are connected through each normal conductive film 4, resulting in a weak coupling due to the proximity effect between the adjacent superconductive pieces 3, when a Cooper pair composed of the superconductive pieces 3 is penetrated into the normal conductive film 4.

In the superconductive magneto-resistive device of the preferred embodiment, each superconductive pieces 3 and each normal conductive film 4 are alternatively formed on the magnesia substrate 1 so as to be connected to each other in series. Namely, a plurality of a set 20 composed of the adjacent two superconductive fine pieces 3 and the normal conductive film 4 arranged therebetween (referred to as a superconductor set 20 hereinafter) are connected in series so as to be formed in a shape of a pattern folded several times, as shown in Fig. 3a.

A fabricating process for the superconductive magneto-resistive device of the preferred embodiment will be described below in detail with reference to partial cross sectional views shown in Figs. 4a to 4d.

Referring to Fig. 4a, materials of Y, Ba and Cu for forming a superconductor are evaporated by the electron beam heating method and sprayed onto a top surface of the non-magnetic magnesia substrate 1 of MgO having an orientation surface of (100). Then, the evaporated materials are oxidized using an oxygen gas before the evaporated materials reach the top surface of the magnesia substrate 1, so as to form an oxide superconductive film 2 of Y₁Ba₂Cu₃Oₓ having a thickness of about 0.5 µms on the magnesia substrate 1, under the condition that the magnesia substrate 1 is heated at a temperature of 650 °C and the oxygen gas is flown onto the top surface of the magnesia substrate 1 so as to keep the gas close thereto at a pressure of about 5 mTorr. It is to be noted that a critical temperature Tc of the oxide superconductive film 2 made by the present inventors was 80 K, and-a critical current Jc thereof was 2 × 10⁵ A/cm².

Thereafter, referring to Fig. 4b, the superconductive film 2 is etched using a predetermined pattern by either the photolithography etching method using electron beam or the reactive sputtering method using a Cℓ gas so as to form plural superconductive fine pieces 3 at predetermined approximately equal spaces on an area of the top surface of the magnesia substrate 1 except for at least the peripheral portions la thereof, wherein a length g of each gap 10 formed between the adjacent superconductive fine pieces 3 is about 0.5 µms, and each of the superconductive fine pieces 3 has a width of about 5 µms and a longitudinal length of about 10 µms.

Thereafter, referring to Fig. 4c, plural normal conductive Au films 4 having a thickness of about 3 µms are formed in the respective gaps 10 so as to connect the adjacent superconductive fine pieces 3, resulting in a weak coupling between the adjacent superconductive fine pieces 3 of the oxide superconductor. Then, plural superconductive fine pieces 3 are connected in series so that each pair of the adjacent superconductive fine pieces 3 are connected through each normal conductive film 4, and the superconductive fine piece 3 and the normal conductive film 4 are arranged alternatively.

Thereafter, referring to Fig. 4d, there are formed a pair of current electrodes 5 of Ti having a thickness of about 0.5 µms for supplying a direct-current bias current to the superconductive magneto-resistive device on respective end top surfaces of both ends of the superconductive fine pieces 3, and there are formed a pair of voltage electrodes 6 of Ti having a thickness of about 0.5 µms for detecting a voltage generated by the superconductive magneto-resistive device on the inside of the current electrodes 5 of respective top surfaces of both ends of the superconductive fine pieces 3. Thus, the superconductive magneto-resistive device of the preferred embodiment can be obtained.

An action of the superconductive magneto-resistive device shown in Figs. 3a and 3b will be described below in detail.

In the superconductive magneto-resistive device, there is caused the proximity effect due to the weak coupling between the adjacent superconductive fine pieces 3 through the normal conductive film 4.

When no magnetic field is applied thereto, respective contacting portions of each Cooper pair composed of the adjacent superconductive fine pieces 3 formed on both sides of the normal conductive film 4, which are in contact to the normal conductive film 4, penetrate into the normal conductive film 4, resulting in a weak coupling between the superconductive fine pieces 3, and then, each normal conductive film 4 has a superconductive property. Namely, characteristic curves of respective wave functions of the above-mentioned Cooper pair are overlapped in the center portion of the normal conductive film 4, and then, a superconductive current flows in the normal conductive film 4.

Furthermore, when a very weak magnetic field is applied thereto, the coherence length of the Cooper pair penetrating into the normal conductive film 4 becomes short, namely, the decay length of the Cooper pair becomes short. Then, there is no overlap between the characteristic curves of respective wave functions of the Cooper pair, resulting in a contact state between the superconductive fine piece 3 and the normal conductive film 4 wherein the above-mentioned superconductive current does not flow in the normal conductive film 4. Therefore, the above-mentioned superconductor set 20 composed of the adjacent superconductive fine pieces 3 and the normal conductive film 4 formed therebetween has a resistance characteristic depending on a magnetic flux density of a magnetic field to be applied thereto. Namely, there is obtained the superconductor set 20, wherein there are changed the distributions of respective wave functions of the Cooper pair penetrated into the normal conductive film 4, depending on a magnetic filed applied thereto.

Furthermore, when plural superconductor sets 20 are connected in series as shown in Figs. 3a and 3b, there can be obtained the superconductive magneto-resistive device having a high sensitivity since there can be obtained a large change in the resistance thereof for an extremely small magnetic field applied thereto. Then, a rate of change in the resistance thereof can be changed by changing the number of the above superconductor set 20.

Since the decay length of the Cooper pair penetrated into the normal conductive film 4 changes depending on a carrier density or an electron mobility of the normal conductive film 4, the length g of each gap 10 is set at a predetermined desirable value by selecting the material of the normal conductive film 4. Furthermore, an energy gap and the coherence length of the Cooper pair can be changed by selecting the material of the superconductive fine pieces 3. Therefore, there can be changed characteristics of the superconductive magneto-resistive device of the preferred embodiment by selecting respective materials of each normal conductive film 4 and each superconductive fine piece 4.

Further, when a normal conductive film 4 is used having a relatively long coherence length of the Cooper pair, the length of each normal conductive film 4 formed between the adjacent superconductive fine pieces 3 can be increased. Therefore, there can be easily fabricated the superconductive magneto-resistive device of the preferred embodiment according to a predetermined specification. Furthermore, the sensitivity of the superconductive magneto-resistive device for detecting a magnetic field can be changed by changing the length g of each gap 10.

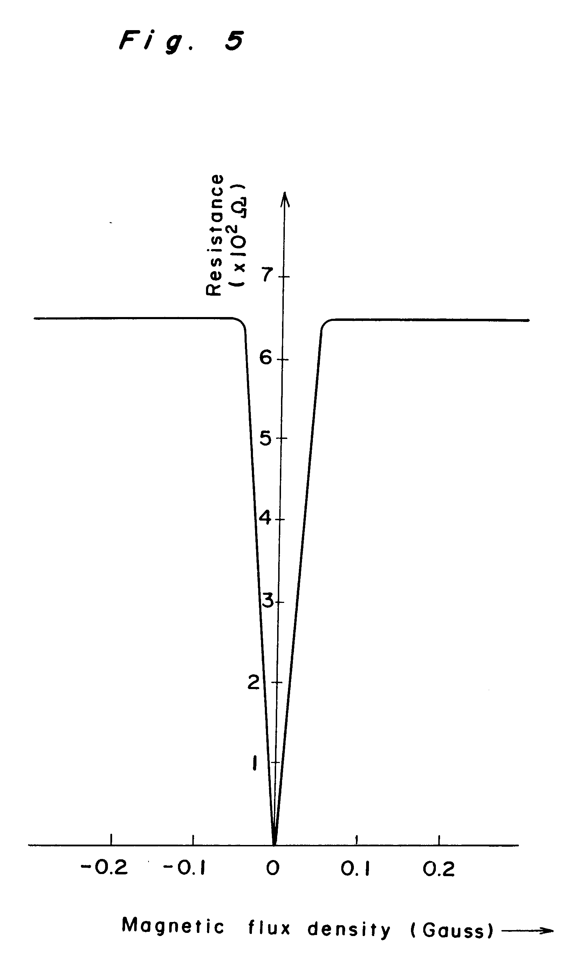

Fig. 5 shows a resistance characteristic of the superconductive magneto-resistive device of the preferred embodiment fabricated as described above depending on a magnetic flux density of a magnetic field applied thereto under the condition of a direct-current bias current of 0.1 mA, which was obtained by a measurement performed by the present inventors.

As is apparent from Fig. 5, the resistance thereof changes steeply in the range of a weak magnetic field applied thereto as a magnetic field is changed. Therefore, a high sensitivity for detecting an extremely weak magnetic field can be obtained.

The superconductive magneto-resistive device having the resistance characteristic on the magnetic flux density shown in Fig. 5 has a maximum rate of increase in the resistivity of 7·10⁷ Ω/Tesla (7 × 10³ Ω/Gauss), corresponding to a maximum sensitivity of about 10⁴ V/Tesla (1 V/Gauss) under the above measurement condition. Therefore, for example, the superconductive magneto-resistive device thereof can detect an extremely weak magnetic field such as about 10⁻¹¹ Tesla (10⁻⁷ Gauss) using a voltage detecting meter having a minimum detection level of 0.1 µV.

Accordingly, the superconductive magneto-resistive device of the preferred embodiment has a sensitivity higher than the conventional superconductive magneto-resistive devices of a material such as a semiconductor, a magnetic material having the resistance characteristic on the magnetic flux density shown in Fig. 1, and also can detect the magnetic field precisely.

In the present preferred embodiment, the oxide superconductor of Y-Ba-Cu-O group is used as the superconductive fine pieces 3, however, the present invention is not limited to this. There may be used a superconductor of Nb group or Pb group, a superconductor of Nb-Ge alloy group or Nb-Aℓ alloy group, or a superconductor of Bi-Sr-Ca-Cu-O group or Tℓ-Ba-Ca-Cu-O group.

In the present preferred embodiment, the normal conductive films 4 is made of Au, however, the present invention is not limited this. There may be used a metal such as Ag, Ti, or a semiconductor such as Ge, Si. In case of the films 4 of a semiconductor, there are used the superconductive fine pieces 3 of a superconductive material of either Y-Ba-Cu-O group, Bi-Sr-Ca-Cu-O group, Tℓ-Ba-Ca-Cu-O group, Nb group, Pb group, Nb-Ge alloy group, or Nb-Aℓ alloy group.

Alternation of respective materials of the superconductive fine pieces 3 and/or the normal conductive films 4, and/or alternation of the length g of each gap 10 and the width of each normal conductive film 4 can control the sensitivity and the output voltage of the superconductive magneto-resistive device of the preferred embodiment.

## Claims

1. A superconductive magneto-resistive device comprising:
plural superconductive pieces (3) formed onto a top surface of a non-magnetic substrate (1), said plural superconductive pieces (3) forming a plurality of pairs, each of said plurality of pairs being formed from adjacent superconductive pieces (3) separated by a small gap (10); and
films (4) selected from the group consisting of a conductive or semiconductive material formed between each pair of said adjacent superconductive pieces (3) on said substrate (1) so as to be in contact with each pair of said adjacent superconductive pieces (3), said films (4) functioning to form a weak coupling due to a proximity effect between each pair of said adjacent superconductive pieces (3).

2. The device as claimed in claim 1, wherein said plural superconductive pieces (3) are connected in series so that each pair of said adjacent superconductive pieces are connected through each of said films (4).

3. The device as claimed in claim 1 or claim 2, further comprising:
a pair of current electrodes (5) for supplying a bias current to said device, said current electrodes (5) being formed on both ends of said superconductive pieces (3); and
a pair of voltage electrodes (6) for detecting a voltage generated by said device, said voltage electrodes (6) being formed on respective insides of said current electrodes (5) on said both ends of said superconductive pieces (3).

4. The device as claimed in any one of claims 1 to 3, wherein each of said superconductive pieces (3) is made of an oxide superconductive material; and
each of said films (4) is made of a normal conductive material.

5. The device as claimed in any one of claims 1 to 3, wherein each of said superconductive pieces (3) is made of an oxide superconductive material; and
each of said films (4) is made of a semiconductive material.

6. A device according to any one of claims 1 to 5, wherein said superconductive pieces (3) and films (4) are positioned on said substrate (1) so as to form a current path which follows a meandering line having at least one hairpin bend.

## Patentansprüche

1. Supraleitende magnetoresistive Vorrichtung mit:
mehreren supraleitenden Stücken (3), die auf einer oberen Oberfläche eines unmagnetischen Substrats (1) vorgesehen sind, wobei die mehreren supraleitenden Stücke (3) mehrere Paare bilden, und jedes der mehreren Paare aus benachbarten supraleitenden Stücken (3) gebildet wird, die durch einen kleinen Spalt (10) getrennt sind; und
Filmen (4), die aus der Gruppe ausgewählt sind, die aus einem leitenden oder halbleitenden Material besteht, und zwischen jedem Paar der benachbarten supraleitenden Stücke (3) auf dem Substrat (1) so vorgesehen sind, daß sie in Berührung mit jedem Paar der benachbarten supraleitenden Stücke (3) stehen, wobei die Filme (4) zur Erzeugung einer schwachen Kopplung infolge eines Naheffektes zwischen jedem Paar der benachbarten supraleitenden Stücke (3) dienen.

2. Vorrichtung nach Anspruch 1, bei welcher die mehreren supraleitenden Stücke (3) in Reihe geschaltet sind, so daß jedes Paar der benachbarten supraleitenden Stücke durch jeden der Filme (4) verbunden ist.

3. Vorrichtung nach Anspruch 1 oder Anspruch 2, welche weiterhin aufweist:
ein Paar von Stromelektroden (5) zur Zufuhr eines Vormagnetisierungsstroms zu der Vorrichtung, wobei die Stromelektroden (5) auf beiden Enden der supraleitenden Stücke (3) vorgesehen sind; und
ein Paar von Spannungselektroden (6) zur Erfassung einer von der Vorrichtung erzeugten Spannung, wobei die Spannungselektroden (6) auf jeweiligen Innenseiten der Stromelektroden (5) auf den beiden Enden der supraleitenden Stücke (3) vorgesehen sind.

4. Vorrichtung nach einem der Ansprüche 1 bis 3, bei welcher jedes der supraleitenden Stücke (3) aus einem supraleitenden Oxidmaterial besteht; und
jeder der Filme (4) aus einem normalleitenden Material besteht.

5. Vorrichtung nach einem der Ansprüche 1 bis 3, bei welcher jedes der supraleitenden Stücke (3) aus einem supraleitenden Oxidmaterial besteht; und
jeder der Filme (4) aus einem Halbleitermaterial besteht.

6. Vorrichtung nach einem der Ansprüche 1 bis 5, bei welcher die supraleitenden Stücke (3) und die Filme (4) so auf dem Substrat (1) angeordnet sind, daß sie einen Stromweg bilden, der einer Mäanderlinie folgt, die zumindest eine Haarnadelkurve aufweist.

## Revendications

1. Dispositif magnétorésistif supraconducteur comprenant:
plusieurs pièces supraconductrices (3) formées sur une surface supérieure d'un substrat (1) non magnétique, lesdites plusieurs pièces supraconductrices (3) formant une pluralité de paires, chacune de ladite pluralité de paires étant formée à partir de pièces supraconductrices adjacentes (3) séparées par un petit intervalle (10); et
des films (4) sélectionnés parmi le groupe consistant en un matériau conducteur ou semiconducteur formé entre chaque paire desdites pièces supraconductrices adjacentes (3) sur ledit substrat (1) de manière à être en contact avec chaque paire desdites pièces supraconductrices adjacentes (3), lesdits films (4) fonctionnant pour former un couplage faible dû à un effet de proximité entre chaque paire desdites pièces supraconductrices adjacentes (3).

2. Dispositif selon la revendication 1, dans lequel lesdites pièces supraconductrices (3) sont connectées en série de telle sorte que chaque paire desdites pièces supraconductrices adjacentes sont connectées par l'intermédiaire de chacun desdits films (4).

3. Dispositif selon la revendication 1 ou la revendication 2, comprenant en outre:
une paire d'électrodes de courant (5) pour appliquer un courant de polarisation audit dispositif, lesdites électrodes de courant (5) étant formées sur les deux extrémités desdites pièces supraconductrices (3); et
une paire d'électrodes de tension (6) pour détecter une tension générée par ledit dispositif, lesdites électrodes de tension (6) étant formées sur les intérieurs respectifs desdites électrodes de courant (5) sur lesdites deux extrémités desdites pièces supraconductrices (3).

4. Dispositif selon l'une quelconque des revendications 1 à 3, dans lequel chacune desdites pièces supraconductrices (3) est réalisée en un matériau supraconducteur oxyde; et
chacun desdits films (4) est réalisé en un matériau conducteur normal.

5. Dispositif selon l'une quelconque des revendications 1 à 3, dans lequel chacune desdites pièces supraconductrices (3) est réalisée en un matériau supraconducteur oxyde; et
chacun desdits films (4) est réalisé en un matériau semiconducteur.

6. Dispositif selon l'une quelconque des revendications 1 à 5, dans lequel lesdites pièces supraconductrices (3) et les films (4) sont positionnés sur ledit substrat (1) de manière à former un trajet de courant qui suit une ligne en méandres ayant au moins une courbe en épingle à cheveux.
